# EUROPEAN PATENT SPECIFICATION

(11) **EP 2 438 133 B1**
(45) Date of publication and mention of the grant of the patent: **11.07.2018**
(21) Application number: 10724054.1
(22) Date of filing: 27.05.2010
(51) Int. Cl.: C09K 3/14, C09G 1/02, H01L 21/306

(54) **Polishing slurry containing raspberry-type metal oxide nanostructures coated with CeO2**
POLIERSUSPENSION MIT CEO2-NANOPARTIKEL BESCHICHTETEN HIMBEERARTIGEN METALLOXIDNANOSTRUKTUREN
COMPOSITION DE POLISSAGE CONTENANT DES NANOSTRUCTURES D'OXYDE DE MÉTAL DE TYPE FRAMBOISE ENROBÉES AVEC DES NANOPARTICULES DE CEO2

(30) Priority: 05.06.2009 EP 09162098
(43) Date of publication of application: 11.04.2012
(73) Proprietor: BASF SE, 67056 Ludwigshafen am Rhein (DE)
(72) Inventor: ZHANG, Zhihua, Singapore 120611 (SG); DALVI, Vaibhav, Singapore 1206047 (SG); MEHTA, Bir Darbar, Singapore 399710 (SG); FECHTENKÖTTER, Andreas, Singapore 098642 (SG); LI, Yuzhuo, 69123 Heidelberg (DE); LAUTER, Michael, 67069 Ludwigshafen (DE)
(86) International application number: PCT/EP2010/057336
(87) International publication number: WO 2010/139603

(56) References cited:
- WO-A1-2005/035688
- WO-A2-2004/031455
- US-A1- 2002 177 311
- US-A1- 2007 264 502
- CHOI K S ET AL: "Engineered porous and coated silica particulates for CMP applications" MATERIALS RESEARCH SOCIETY SYMPOSIUM - PROCEEDINGS 2001 MATERIALS RESEARCH SOCIETY US, vol. 671, 2001, pages M5.8.1-M5.8.10, XP002598215
- H.-C. KIM, H. M. LIM, D.-S. KIM, S.-H. LEE: "Effect of particle size of ceria coated silica and polishing pressure on chemical mechanical polishing of oxide film" TRANSACTIONS ON ELECTRICAL AND ELECTRONIC MATERIALS, vol. 7, no. 4, 1 August 2006 (2006-08-01), pages 167-172, XP002598971 ISSN: 1229-7607 DOI: http://www.koreascience.or.kr/journal/view .jsp?issn=1229-7607&vo
- X. SONG, N. JIANG, Y. LI, D. XU, G. QIU: "SYNTHESIS OF CEO2-COATED SIO2 NANOPARTICLE AND DISPERSION STABILITY OF ITS SUSPENSION" MATERIALS CHEMISTRY AND PHYSICS, vol. 110, no. 1, 18 March 2008 (2008-03-18), pages 128-135, XP002598972 ISSN: 0254-0584 DOI: http://www.sciencedirect.com/science?_ob=A rticleURL&_udi=B6TX4-4

## Description

### Field of the Invention

The invention relates to polishing slurry containing raspberry-type coated particles comprising a core selected from the group of metal oxides of Si, Ti, Zr, Al, Zn and mixtures thereof wherein the core is coated with CeO₂ particles, a process for preparing these particles, the use of these particles for polishing, especially for chemical mechanical planarization (CMP).

### Cited Documents

The documents cited in the present application are incorporated by reference in their entirety.

### Description of the Prior Art

Chemical mechanical planarization slurries are intensively used to planarize semiconductor wafers or other substrates for integrated circuits (IC) and semiconductor fabrication. Typically these slurries contain reactive chemicals such as oxidants, complexation agents and so on, as well as mechanical abrasive particles such as SiO₂, CeO₂ and Al₂O₃ etc. Among them, CeO₂ (ceria) has received intensive attention due to its good hardness, higher polishing rate and its distinct oxidative ability.

It is widely accepted that size, shape and composition of the abrasive particles play an important role in determining the polishing rate and surface qualities. Very fine abrasive particles attracted great attention due to the development of semiconductor chips with nodes of smaller size. On one hand, larger particles give a higher removal rate, but create micro-scratches on the substrate surfaces and produce worse surface finishing. On the other hand, while ceria particles smaller than 50 nm produce better surface finishing quality, they give very low polishing rates. In addition, nanosized ceria particles are poorly dispersable in water since they agglomerate more easily than other kinds of particles like silica, alumina and zirconia.

From US 2004/0211337 A1 it is known to improve the stability of ceria and the polishing rate of the slurry. Compared to uncoated ceria, silica coated ceria slurry showed better removal performance. However, the polishing rate is still not high.

US 2003/0118824 A1 relates to silica particles coated with CeO₂ the coated particles having a particle size of from 1 to 200 nm for use in polishing applications. The particles are prepared from an alkaline solution containing silica particles, a water-soluble CeO₂ precursor and an oxidizing agent by oxidizing the CeO₂ precursor. The "removal rate" caused by the particles in a polishing agent is higher for the CeO₂ coated silica particles than for conventional silica particles.

However, M.-S. Tsai, Mat. Sci. Eng. B 110 (2004), pages 132 to 134 shows, that the presence of H₂O₂ impairs the polishing performance of pure CeO₂ particles. Therefore CeO₂ coated particles prepared with H₂O₂ as described in US 2003/0118824 A1 have to be freed from the oxidizing agent very carefully.

WO 2005/035688 A1 discloses an abrasive for chemical mechanical polishing, which is produced by hydrothermally treating a ceria particle coated silica. The abrasive particles each include a silica core having a particle size of from 20 to 400 nm, a ceria shell having a thickness of from 5 to 20 nm and a silica shell having a thickness of less than 2 nm. The abrasive particles have a particle size of from 50 to 500 nm. The intermediate particles to be hydrothermally treated can be prepared by preparing a ceria sol from a water-soluble CeO₂ precursor by adding ammonia and mixing the resulting suspension with a colloidal silica slurry.

US 6,110,396 and US 6,238,469 B1 both disclose CMP slurries containing abrasive silica particles having a particle size of from 10 to 1000 nm and preferably 50 to 100 nm. The CMP slurries furthermore contain a colloidal dual valent rare earth hydroxide wherein the rare earth is in its higher valent form. The hydroxide particles have a particle size of from 5 to 100 nm, specifically 20 nm. They provide a much greater source of OH radicals as, for instance, fired ceria particles. The example 5 of both patents discloses the addition of an aqueous solution of ammonium Ce (IV) nitrate to a basic slurry of silica having a particle size of 50 nm. No mention is made as to whether raspberry-type abrasive particles are obtained, isolated and fired.

US 6,645,265 B1 discloses CeO₂ coated SᵢO₂ particles for standard glass polishing. The core particles have a particle size from 20 to 2000 nm. Colloidal silica having a particle size of from 10 to 100 nm can be used. The CeO₂ shell has a thickness as estimated from the weight increase of the particles of from 1 to 20, preferably from 2 to 10 nm. The particles are prepared by adding an aqueous solution of ammonia or urea to an aqueous solution of Ce(III) nitrate and silica sol. The resulting suspension is aged at 90°C for about 16 hours, followed by separation, drying and firing of the coated particles at 800°C for 2 hours. In the examples, the starting material, i. e., the uncoated SiO₂ particles, have a diameter of 300 nm. Moreover, the US patent teaches that the isolated coated particles are fired at from 600 to 1000°C to form the ceria as a thin shell on the surface of the SiO₂ particles so that no raspberry-type structure is obtained. Moreover, at these high firing temperatures, a sintering of the core of the particles frequently occurs yielding particles, the property profile of which cannot be reproduced in a reliable manner. Furthermore, the high firing temperatures can cause considerable aggregation of the particles.
K. S. Choi et al., Mat. Res. Soc. Symp. Proc. Vol. 671, 2001 Materials Research Society, M5.8.1 to M5.8.10 disclose engineered porous and coated silica particulates for CMP applications. The coated particles have a particle size of 280 nm. This silica core particles have a particle size of 200 nm and the ceria particles have a particle size of 20 nm. The coated particles can be prepared by directly mixing a ceria suspension and a porous silica solution. In another alternative, Ce (III) nitrate is dissolved in water. Thereafter, aqueous ammonium hydroxide is added. The resulting suspension is mixed with microporous silicon powders. The resulting particles are isolated, dried and calcined at 400°C.
S.-H: Lee et al., J. Mater. Res., Vol. 17, No. 10, (2002), pages 2744 to 2749 describe the preparation of silicon particles with a diameter of 300 and 400 nm by heating an aqueous solution of Ce (III) nitrate and NH₄OH to 93°C, admixing aqueous colloidal silica and stirring the system at this temperature. The coated particles show much higher polishing rates than the pure CeO₂ or SiO₂ particles as evaluated for the polishing of thermal SiO₂ wafers. The maximum polishing rate obtained is 1150 angstrom/min.
A. Jindal et al., Journal of the Electrochemical Society, 150 (5) G314-G318 (2003) disclose chemical mechanical polishing of dielectric films using mixed abrasive slurries. The mixed abrasive slurries comprise colloidal alumina having a mean aggregate size of 180, 250, and 100 nm, respectively. The ceria particles have a particle size from 10 to 15 or 30 to 35 nm and are stabilized by acetate or nitrate counterions. It is believed that the absorbed ceria particles form bumps on the larger alumina particles, resulting in a synergistic combination of the chemical tooth action of ceria and the hardness of the alumina particles. The abrasive slurries exhibit a comparatively high polishing selectivity of oxide over nitride.
Z. Lu, Journal of Materials Research, Vol. 18, No. 10, October 2003, Materials Research Society describe the effects of mixed abrasive and chemical mechanical polishing of oxide films with slurries containing abrasive particles with a silica core having a particle size of 400 or 700 nm or with a hematite core having a particle size of 700 nm and a shell of ceria particles having a particle size of 20 nm. The coated particles are prepared by adding a silica suspension to a ceria suspension at pH 4 and keeping the mixture at room temperature or at 83°C for 1 hour.
S. Hedge et al., Electrochemical and Solid-State Letters, 7 (12) G316-G318 (2004) disclose a study of surface charge effects on oxide and nitride planarization using alumina/ceria mixed abrasive slurries. The mixed abrasive slurries are prepared by mixing alumina slurries containing alumina particles of a mean particle size of 170 nm and ceria slurries containing ceria particles stabilized by nitrate or acetate counterions and having a mean particle size of 15 nm. The mixed abrasive slurries exhibit a polishing selectivity of oxide over nitride.
S. Armini et al., Journal of the Electrochemical Society, 155 (4) H218-H223 (2008) disclose a study on the interaction force is between a glass surface and ceria-modified PMMA-based abrasives for CMP measured by a colloidal probe AFM. The ceria particles used have a particle size of 14 nm, whereas the PMMA-terpolymer particles have particle sizes of about 350 nm.

A method and a slurry for CMP of a structure including at least one metal metal based film and a least one underlying dielectric film based on a selective adsorption additive is disclosed in WO 2004/031455 A2.

WO 2005/035688 A1 discloses an abrasive for CMP comprising a silica core and a first shell for coating the silica core made of ceria particles.

Despite the fact that particles for chemical mechanical polishing are known from the state of the art, there is still a need of abrasive particles for CMP with improved polishing properties which can be prepared in a simplified process. Moreover, although some of the prior art CMP slurries containing raspberry type abrasives exhibit an oxide over nitride selectivity in CMP, the selectivity needs further improvement.

EP 1 061 111 A1 discloses abrasive compositions for polishing semiconductor devices comprising ceria a having a particle size of from 10 to 1000 nm, preferably 5 to 500 nm and a water-soluble organic compound having at least one carboxylic acid or carboxylate group or at least one sulfonic acid or sulfonate group such as polyacrylic acid, polymethacrylic acid, glutamic acid or laurylbenzyl sulfuric acid and their ammonium salts. Although the additives are capable of increasing the oxide over nitride selectivity, the drawbacks associated with the use of pure ceria particles are not ameliorated.

US 6,616,514 B1 discloses abrasive compositions for CMP comprising ceria having a particle size of from 20 to 1000 nm and an organic polyol such as mannitol, sorbitol, mannose, xylitol, sorbose, sucrose, and dextrin. The organic polyol increases the oxide over nitride selectivity. Nevertheless, the drawbacks associated with the use of pure ceria particles are not ameliorated.

US 2004/0152309 A1, US 2006/0114824 A1 or US 7,071,105 B2 disclose abrasive compositions for CMP comprising ceria having a particle size of about 180 nm or less, typically 20 nm or more, and a polishing additive comprising a functional group having a pKa of about 4 to about 9, the polishing additive being selected from the group consisting of arylamines, aminoalcohols, aliphatic amines, heterocyclic amines, hydroxamic acids, cyclic monocarboxylic acids, unsaturated monocarboxylic acids, substituted phenols, sulfonamides, thiols, salts thereof, and combinations thereof. It is said that the polishing additives increase the oxide over nitride selectivity. However, the drawbacks associated with the use of pure ceria remain.

As regards the selectivity enhancing effect of certain compounds, the teaching of the prior art can be contradictory. Thus, according to comparative example 1S of US 2004/0152309 A1, US 2006/0114824 A1 or US 7,071,105 B2, malic acid shows no selectivity enhancing effect, whereas it does so according to example 18 of EP 1 061 111 A1. This shows that the selection of a polishing additive for a given abrasive in order to obtain a polishing agent having a high oxide over nitride selectivity is not trivial because the selectivity is also influenced by other parameters in an unpredictable manner.

### Objects of the Invention

It was an objective of the present invention to develop a cost-effective and convenient process to produce an efficient polishing slurry by coating cheaper inert cores with abrasive compounds which are more expensive. The loading of the costly materials should be decreased while keeping the active surface area more or less at the same level as for the pure abrasive particles and obtaining similar results in respect to polishing rate and surface quality of the polished surface.

Moreover, it was an object of the present invention to develop a cost-effective and efficient polishing slurry having a particularly high oxide over nitride selectivity, in particular, silicon dioxide over silicon nitride selectivity, and not exhibiting the drawbacks associated with the use of pure ceria particles.

### Summary of the Invention

This object is achieved according to the invention by the polishing slurry containing raspberry-type coated particles comprising a core selected from the group consisting of metal oxides of Si, Ti, Zr, Al, Zn and mixtures thereof with a core size of from 20 to 100 nm wherein the core is coated with CeO₂ particles having a particle size below 10 nm.

Moreover, the object is achieved by the polishing slurry containing raspberry-type coated particles obtainable by the process comprising the steps of
i) providing a mixture containing
   a) core particles selected from the group consisting of of metal oxides of Si, Ti, Zr, Al, Zn and mixtures thereof with a particle size of from 20 to 100 nm,
   b) at least one water soluble Ce-salt and
   c) water,
ii) adding at least one organic or inorganic base to the mixture of step i) at temperatures of from 10 to 90°C,
iii) aging the mixture at temperatures of from 10 to 90°C, whereby the pH-value decreases during the aging step,
iv) separating the particles from the mixture, and
v) treating the particles at temperatures of from 150 to 400°C,
wherein the raspberry-type particles contain 50 to 97 wt.% of the core and 3 to 50 wt.% CeO₂.

Hereinafter, the raspberry-type coated particles are referred to as the particles used according to the invention.

Furthermore, the object is achieved by the process for preparing raspberry-type coated particles comprising the steps of
i) providing a mixture containing
   a) core particles selected from the group consisting of metal oxides of Si, Ti, Zr, Al, Zn and mixtures thereof with a particle size of from 20 to 100 nm,
   b) at least one water soluble Ce-salt and
   c) water,
ii) adding at least one organic or inorganic base to the mixture of step i) at temperatures of from 10 to 90°C, and
iii) aging the mixture at temperatures of from 10 to 90°C, the pH-value decreases during the aging step,

Hereinafter, the process for preparing raspberry-type coated particles is referred to as the "process according to the invention".

Additionally, the object is achieved by a polishing slurry containing
(A) at least one type of abrasive particles comprising a core selected from the group consisting of metal oxides of Si, Ti, Zr, Al, Zn and mixtures thereof with a core size of from 20 to 100 nm wherein the core is coated with CeO2 particles having a particle size below 10 nm, whereby the raspberry-type coated particle is a particle comprising a core and a coating wherein the coating is deposited on the core as distinguishable dots or spheres instead of an even layer or shell, and
(B) at least one polishing additive selected from the group consisting of
   (b1) compounds having at least one functional group selected from the group consisting of carboxylic acid group, carboxylate group, sulfonic acid group or sulfonate group;
   (b2) polyols having hydroxyl groups that are not dissociable in the aqueous medium;
   (b3) compounds having at least one functional group having a pKa of about 4 to about 9 and being selected from the group consisting of arylamines, aminoalcohols, aliphatic amines, heterocyclic amines, hydroxamic acids, cyclic monocarboxylic acids, unsaturated monocarboxylic acids, substituted phenols, sulfonamides, thiols, and salts thereof; and
(C) at least one liquid carrier.

Hereinafter, the polishing slurry is referred to as the "polishing slurry according to the invention" or "suspension according to the invention".

Last but not least, the object is achieved by the use of the particles prepared in accordance with the process according to the invention and of the suspension according to the invention for polishing surfaces.

### Detailed Description of the Invention

In the context of the present invention, the particle size of the various particles is determined by known and customary methods, in particular, by laser diffraction.

The particles according to the invention are especially well suited for the chemical mechanical polishing of SiO₂ wafers used for integrated circuits and semiconductor fabrication. Despite the general knowledge that particles with a diameter less than 50 nm give only small polishing rates and good surface finishing, whereas with large particles high polishing rates and worse surface finishing are obtained, the comparably small particles according to the invention have unexpectedly high polishing rates combined with good surface quality of the polished surfaces and with good surface uniformity.

The process according to the invention for preparing raspberry-type coated particles is a very simple, non-complicated process wherein the main steps of the synthesis (i. e. steps ii) and iii)) are carried out at comparatively low temperatures. It is even possible to use room temperature in the process steps ii) and iii).

The particles prepared by the process according to the invention show high polishing rates even without calcination. To increase the polishing rate of the particles even more, it is sufficient to treat them at lower temperatures of from 150 to 400°C in contrast to the calcination process performed at temperatures of from 600 to 1000°C known from the state of the art. The particles according to the invention, which are not calcined or calcined at 150 to 400°C are milled more easily than particles calcined at higher temperatures such as 800°C, i.e., less energy is required during milling.

Raspberry-type coated particle according to the invention means a particle comprising a core and a coating wherein the coating is deposited on the core as distinguishable dots or spheres instead of an even layer or shell. The outside appearance of the particle can be imagined as a kind of raspberry. In a preferred embodiment the raspberry-type coated particle consists of the core and the coating.

The core is selected from the group consisting of metal oxides of Si, Ti, Zr, Al, Zn and mixtures thereof. Preferably the core is selected from the group consisting of SiO₂, TiO₂, ZrO₂, Al₂O₂, ZnO and mixtures thereof. In an even more preferred embodiment the core is SiO₂, especially either fumed silica, a non-crystalline, low density and high surface area silica, or silica gel, a granular and highly porous form of silica made from sodium silicate. Especially preferred are commercially available aqueous suspensions of silica such as Levasil®, Nexsil® series, etc. Moreover, suitable silica nanoparticle dispersions can be acquired by the sol-gel approach.

The core size is of from 20 to 100 nm, preferably of from 50 to 80 nm. The core is preferably of spherical or nearly spherical shape.

The core is coated with CeO₂ particles, which have a particle size of below 10 nm, preferably a particle size of from 2 to 5 nm.

The particles according to the invention comprise 50 to 97 wt%, preferably 70 to 90 wt% and more preferably 75 to 85 wt% of the core and 3 to 50 wt%, preferably 10 to 30 wt% and more preferably 15 to 25 wt% of CeO₂, based on the total weight of the particles according to the invention, respectively. In a preferred embodiment the particles according to the invention consist essentially of 50 to 97 wt%, preferably 70 to 90 wt% and more preferably 75 to 85 wt% of the core and 3 to 50 wt%, preferably 10 to 30 wt% and more preferably 15 to 25 wt% of CeO₂, based on the total weight of the particles according to the invention, respectively, and more preferably consist of 60 to 80 wt%, preferably 70 to 80 wt% of the core and 20 to 40 wt%, preferably 20 to 30 wt% of CeO₂, based on the total weight of the particles according to the invention, respectively.

The process according to the invention for preparing raspberry-type coated particles, in particular the particles according to the invention, comprises at least the three steps i) to iii) cited above. In the first step a mixture containing
a) core particles selected from the group consisting of metal oxides of Si, Ti, Zr, Al, Zn and mixtures thereof with a particle size of from 20 to 100 nm,
b) at least one water soluble Ce-salt and
c) water
is prepared.

The concentration of the core particles in the mixture is from 1 to 20 wt%, preferably from 3 to 6 wt.-%, based on the total weight of the mixture of step i). The concentration of the water soluble Ce-salt or -salts is from 0.5 to 6 wt%, preferably from 2 to 3 wt.-%, based on the total weight of the mixture of step i). Usually the remainder is water. In a preferred embodiment the mixture of step i) consists of core particles, at least one water-soluble Ce-salt and water, since several additives may negatively affect the polishing performance of the particles.

The one or more water soluble Ce-salts b) are selected from the group consisting of Ce (III) nitrate, Ce (III) chloride, Ce (III) sulphate, Ammonium Ce (IV) nitrate and Ce(IV) perchlorate. The preferred Ce-salt is Ce (III) nitrate. Water soluble means, that it is possible to prepare a clear solution of the salt in water with a concentration of at least 20 g/L at 20°C.

In step ii) of the process according to the invention at least one organic or inorganic base is added to the mixture of i) at temperatures of from 10 to 90°C, preferably at temperatures of from 15 to 50°C and more preferably of from 18 to 25°C.

The organic or inorganic bases may be selected from all bases known for depositing CeO₂ from aqueous solutions of Ce-salts by the person skilled in the art. For example urea, NaOH, KOH, NH₄OH and alkyl amines like triethylamine may be used. A preferred base according to the invention is triethylamine. In step ii) the base may be added batchwise or dropwise wherein the dropwise addition is preferred.

Usually in step ii) the base is added in an amount enough to alkalize the mixture, i.e. the pH-value will be above 8 and preferably above 10 at the beginning after addition of the base. In general, the ratio of added base to watersoluble Ce-salt is at least 3:1, preferred at least 5:1 and more preferred at least 6:1. Usually the ratio of added base to water-soluble Ce-salt does not exceed 10:1.

In a preferred embodiment of the invention the required amount of base is added at the beginning of step ii), the base may be added dropwise or batchwise and no base is added in further stages of step iii). The pH-value of the mixture decreases therefore during the aging of step iii) and at the end of step iii), i.e., after aging the pH-value of the mixture of step iii) will be lower than the pH-value at the beginning of step iii) after addition of the base. The pH-value of the mixture at the end of step iii) is preferably below 10, more preferred below 9 and especially preferred below 8. In a very preferred embodiment of the invention the pH-value at the end of step iii) is below 6, this is especially preferred, if the added base is triethylamine.

In step iii) the mixture is aged at temperatures of from 10 to 90°C, preferably at temperatures of from 15 to 50°C and even more preferred at temperatures of from 18 to 25°C. The aging may be carried out under stirring the mixture for at least 10 hours. Preferrably, the aging is carried out for 12 to 48 hours and, more preferably, the aging takes 16 to 24 hours.

In a preferred embodiment of the process steps ii) and iii) are carried out at atmospheric pressure. The process steps ii) and iii) may in this case be performed open to the air.

According to another preferred embodiment of the invention, the process according to the invention described above can be carried out without calcining the particles at temperatures above 150°C after step iii).

In yet another preferred embodiment of the invention the process steps i) to iii) of the process according to the invention described above are followed by the steps of
iv) separating the particles from the mixture and
v) treating the particles at temperatures of from 150 to 400°C, preferably of from 180 to 220°C and most preferably at 200°C.

In a further aspect the present invention relates to the particles used according to the invention obtainable by
i) providing a mixture containing
   a) core particles selected from the group consisting of metal oxides of Si, Ti, Zr, Al, Zn and mixtures thereof with a particle size of from 20 to 100 nm
   b) at least one water soluble Ce-salt and
   c) water,
ii) adding at least one organic or inorganic base to the mixture of step i) at temperatures of from 10 to 90°C, preferably from 18 to 25°C,
iii) aging the mixture at temperatures of from 10 to 90°C, preferably from 18 to 25°C, whereby the pH-value decreases during the aging step,
iv) separating the particles from the mixture and
v) treating the particles at temperatures of from 150 to 400°C, preferably of from 180 to 220°C and most preferably at 200°C,
wherein the raspberry-type particles contain 50 to 97 wt.% of the core and 3 to 50 wt.% CeO₂, based on the total weight of the raspberry-type particles.

The separation of the particles from the mixture may be performed by all means known in the art like sedimentation, filtration or centrifugation. Optionally, the particles according to the invention are washed with water. The separated particles according to the invention are treated for at least one hour, preferably at least for two hours and more preferably for at least four hours. The temperature is held at from 150 to 400°C. The preferred treating temperature is of from 180 to 220°C and most preferred the treating is carried out at about 200°C. The treating of the particles in step v) may be performed in the presence of air.

Yet another aspect of the invention is the suspension according to the invention.

The suspension of the invention comprises as the first essential component at least one, preferably one type of abrasive particles (A) comprising coated particles comprising a core selected from the group consisting of metal oxides of Si, Ti, Zr, Al, Zn and mixtures thereof coated with CeO₂.

In principle, any type of coated particles can be used as long as they fulfill these features. Examples for such coated particles are disclosed in, for example, US 2003/0118824 A1, WO 2005/035688 A1, US 6,110,396, US 6,238,469 B1, US 6,645,265 B1, K. S. Choi et al., Mat. Res. Soc. Symp. Proc. Vol. 671, 2001 Materials Research Society, M5.8.1 to M5.8.10, S.-H. Lee et al., J. Mater. Res., Vol. 17, No. 10, (2002), pages 2744 to 2749, A. Jindal et al., Journal of the Electrochemical Society, 150 (5) G314-G318 (2003), Z. Lu, Journal of Materials Research, Vol. 18, No. 10, October 2003, Materials Research Society, and S. Hedge et al., Electrochemical and Solid-State Letters, 7 (12) G316-G318 (2004).

However, most preferably, the abrasive particles (A) are selected from the group consisting of the particles of the invention described hereinbefore.

The concentration of the abrasive particles (A) in the suspension according to the invention can vary broadly and, therefore, can be adjusted advantageously to the requirements of the particular polishing method the suspension according to the invention is used for. Preferably, the concentration is in the range of from 0.01 to 5 wt.%, more preferably 0.1 to 2.5 wt.% and, most preferably, 0.1 to 1.5 wt.%, the weight percentages being based on the complete weight according to the suspension of the invention.

The suspension according to the invention contains at least one polishing additive (B) selected from the group consisting of
(b1) compounds having at least one functional group selected from the group consisting of carboxylic acid group, carboxylate group, sulfonic acid group or sulfonic group, in particular the compounds described in EP 1 061 111 A1, page 3, paragraph [0019] to a page 4, paragraph [0021], preferably glutamic acid;
(b2) polyols having hydroxyl groups, preferably at least 3 hydroxyl groups, that are not dissociable in the aqueous medium, in particular the compounds described in US 6,616,514 B1, column 4, lines 40 to 59, in particular mannitol; and
(b3) compounds having at least one functional group having a pKa of about 4 to about 9 and being selected from the group consisting of arylamines, aminoalcohols, aliphatic amines, heterocyclic amines, hydroxamic acids, cyclic monocarboxylic acids, unsaturated monocarboxylic acids, substituted phenols, sulfonamides, thiols, and salts thereof, in particular the compounds described in US 2004/0152309 A1, page 3, paragraph [0020] to page 5, paragraph [0032], in particular the cyclopropane carboxylic acid and picolinic acid.

The concentration of the polishing additive (B) in the suspension according to the invention can vary broadly and, therefore, can be adjusted advantageously to the requirements of the polishing process wherein the suspension according to the invention is to be used. Preferably, the concentration is in the range of from 0.001 to 5 wt.%, more preferably 0.01 to 4 wt.% and most preferably 0.01 to 3 wt.%, the weight percentages being based on the complete weight of the suspension according to the invention.

The suspension of the invention comprises at least one, preferably one, liquid carrier (C). The liquid carrier can be water or a supercritical liquid such as carbon dioxide. Preferably, water and most preferably ultrapure water is used.

The suspension according to the invention can furthermore contain at least one additional component (D) known from the art of chemical mechanical polishing such as pH adjusters, regulators or buffers, biocides, anti-foaming agents, alcohols, and surfactants, as described for example in US 2004/0152309 A1, page 5, paragraphs [0034] to [0037].

Another aspect according to the invention is the use of the raspberry-type coated particles for polishing surfaces, e. g. for CMP, especially for polishing SiO₂ wafers used for integrated circuits and semiconductors.

Another aspect of the invention is the use of the particles according to the invention, the particles prepared according to the process according to the invention and of the suspension according to the invention for polishing surfaces, in particular silicon dioxide surfaces. The respective polishing slurries may contain further additives.

Most surprisingly, the suspension according to the invention exhibits a particularly high oxide over nitride selectivity when used in a CMP process for polishing semiconductor wafers having silicon dioxide dielectric layers and silicon nitride stopping layers.

In the following the invention is described in detail by working examples.

### Examples 1 to 3

### The Preparation of Raspberry-Type Ceria Coated Silicon Dioxide Particles

### Example 1:

21.72g of Cerium (III) nitrate (99%, Sigma-Aldrich) was dissolved in 780g of water. To this solution, 66.4g of 45 wt.-% silica sol (SiO₂ with particle size of 40 - 50 nm, Levasil® 100, H.C. Stark) in water was added dropwise to obtain a consistent dispersion. 42 ml of triethylamine (98%, Fluka) was added to the above dispersion in 2 equal batches, under vigorous stirring. The pH of the mixture was about 11. The color of the dispersion turned from purple color to final yellow after stirring for 24 hours in open air at room temperature. The pH of the mixture was about 5 to 6. The final product was purified through centrifugation and then re-dispersed into water to produce the desired slurry. (No calcination).

### Example 2:

21.72g of Cerium (III) nitrate (99%, Sigma-Aldrich) was dissolved in 780g of water. To this solution, 66.4g of 45 wt% silica sol (Levasil® 100, H.C. Stark) in water was added dropwise to obtain a consistent dispersion. 42 ml of triethylamine (98%, Fluka) was added to the above dispersion in 2 equal batches under vigorous stirring. The pH of the mixture was about 11. The color of the dispersion turned from purple color to final yellow after stirring for 24 hours in open air at room temperature. The pH of the mixture was about 5 to 6. The final product was purified through centrifugation and was then dried under vacuum overnight. The powder was calcined at 200°C for 4 hrs and then milled with zirconium beads followed by re-dispersion in water to get the desired polishing slurry.

### Example 3:

21.72g of Cerium (III) nitrate (99%, Sigma-Aldrich) was dissolved in 780g of water. To this solution, 75g of 40 wt% silica sol (SiO₂ with particle size of 80 nm, Nexsil® 125, Nyacol) in water was added dropwise to obtain a consistent dispersion. 42 ml of triethylamine (98%, Fluka) was added drop wise to the above dispersion, under vigorous stirring. The pH of the mixture was about 11. The color of the dispersion turned from purple to final yellow after stirring for 24 hours in open air at room temperature. The pH of the mixture was about 5 to 6. The final product was purified through centrifugation and was then dried under vacuum overnight. The powder was calcined at 200°C for 4 hrs and then milled with zirconium beads followed by re-dispersion in water to get the desired polishing slurry.

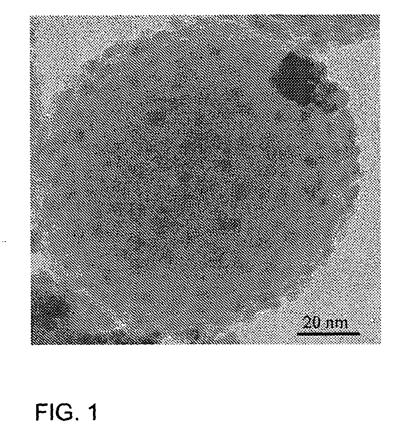

In Figure 1 a TEM image of a raspberry-type coated particle prepared according to Example 3 is shown. The spherical CeO₂-particles on the surface are clearly visible.

### Example 4:

Example 3 was repeated only that the precipitation of the Ce (III) nitrate was conducted in a closed vessel.

### Examples 5 to 7

### The Polishing of Semiconductor Wafers Having Thermal SiO₂ Layers

The polishing slurry of the Example 1 was used for the Example 5. The polishing slurry of the Example 2 was used for the Example 6. The polishing slurry of the Example 3 was used for the Example 7.

### Determination of the Polishing rate:

The polishing (i.e. removal) rate is determined by difference of weight (1.9 kg/L used as density of thermal SiO₂ for calculating removal rates) of the wafers before and after cmp by a Sartorius LA310 S scale or a Filmmetrics F50 reflectometer. The polishing experiments were carried out with a Strasbaugh nSpire (Model 6EC), ViPRR floating retaining ring Carrier with the following parameters:
down pressure: 3.5 psi (240 mbar);
back side pressure: 0.5 psi (34.5 mbar);
retaining ring pressure: 2.5 psi (172 mbar);
polishing table / carrier speed: 95 / 85 rpm;
slurry flow rate: 200 ml / min;
polishing time: 60 s;
pad conditioning: in situ (9.2 - 9.0 lbs, 41 N);
polishing pad: IC1000 A2 stacked pad, xy k grooved (R&H);
backing film: Strasbaugh, DF200 (136 holes);
conditioning disk: Strasbaugh sasol.

The concentration of the aqueous polishing slurries was 0.5 wt% of coated particles, this corresponds to a concentration of 0.11 wt% of CeO₂ and 0.39 wt% of SiO₂ in the polishing slurry.

Aqueous suspensions of SiO₂ particles with a particle size of 50 nm or of 80 nm at a particle concentration of 1 wt% as well as aqueous dispersions of CeO₂- particles with a particle size below 10 nm at a particle concentration of 0.11 wt% used for purposes of comparison showed polishing rates of practically zero.

The results off the polishing experiments according to the Examples 4 to 6 are shown in Table 1.

**Table 1: Polishing Rates**

| **Example** | **SiO₂ [wt%]** | **CeO₂ [wt%]** | **Polishing rate [angstrom/min.]** |
|---|---|---|---|
| 5 | 78 | 22 | 1663 |
| 6 | 78 | 22 | 3518 |
| 7 | 78 | 22 | 4439 |

### Examples 8 to 19

The Silicon Oxide over Silicon Nitride Selectivity of Polishing Slurries Containing Ceria Coated Silicon Dioxide Particles (Examples 8, 10, 13, 15) and of Polishing Slurries Containing Ceria Coated Silicon Dioxide Particles and a Polishing Additive (Examples 9, 11, 12, 14, and 16 to 19)
For the Examples 8 to 19 silicon wafers containing either silicon dioxide layers or silicon nitride layers were used. The polishing experiments were conducted as described in the Examples 5 to 7 with the exception that in the Examples 13 and 14 the down pressure was 3 psi (205.7 mbar) instead of 3.5 psi (240 mbar).

Three batches of polishing agents used for the polishing experiments of the Examples 8 to 14 were prepared according to the Example 3. Batch 1 was used in the Examples 8 and 9. Batch 2 was used in the Examples 10 to 12. Batch 3 was used in the Examples 13 and 14.

One batch of polishing agent (batch 4) used for the polishing experiments of the Examples 15 and 16 was prepared according to Example 4.

Two batches (batches 5 and 6) of the polishing agent used for the polishing experiments of the Examples 17 and 18 were prepared according to Example 3 only that SiO₂ with a particle size of 50 nm (Nexsil® 125, Nyacol) instead of SiO₂ with a particle size of 80 nm (Nexsil® 125, Nyacol) was used.

One batch (batch 7) of the polishing agent used for the polishing experiment of the Example 19 was prepared according to the Example 3 only that the coated particles were not calcined.

The concentration of ceria coated silicon dioxide particles in the polishing agents used in the Examples 8 to 19 was 0.5 wt.%.

The material compositions of the polishing agents of the Examples 8 to 19, their pH and the results of the polishing experiments are compiled in the Table 2.

**Table 2: Material Composition of the Polishing Agents of the Examples 8 to 19 and Polishing Results**

| **Example No.** | **Batch No.** | **Additive** | **Additive concentration** [**wt**.%] | **P H** | **MRR^{a)} SiO₂** | **MRR^{a)} Si₃N₄** | **Selectivity SiO₂/Si₃N₄** |
|---|---|---|---|---|---|---|---|
| 8 | 1 | - | - | 4 | 6118 | 987 | 6.2 |
| 9 | 1 | glutamic acid | | 4 | 2522 | 48 | 52.5 |
| 10 | 2 | - | - | 5 | 5566 | 553 | 10 |
| 11 | 2 | mannitol | | 5 | 6565 | 574 | 11.4 |
| 12 | 2 | mannitol | | 5 | 4593 | 123 | 37.3 |
| 13 | 3 | - | - | 4 | 2633 | 490 | 5.4 |
| 14 | 3 | cyclopropane carboxylic acid | | 4 | 3124 | 56 | 55.8 |
| 15 | 4 | - | - | 4 | 3270 | 736 | 4.4 |
| 16 | 4 | picolinic acid | | 4 | 1749 | 34 | 51.4 |
| 17 | 5 | picolinic acid | | 4 | 2104 | 61 | 34.5 |
| 18 | 6 | sorbitol | | 4 | 3909 | 199 | 19.6 |
| 19 | 7 | glutamic acid | | 4 | 2732 | 47 | 68.1 |

| | | | | | | | |
|---|---|---|---|---|---|---|---|
| a) material removal rate [angstrom/minute] | | | | | | | |

The results of the Table 2 make apparent that the polishing agents not containing polishing additives exhibited a high oxide polishing rate and a comparatively low nitride polishing a rate. The selectivity of the polishing agents could be significantly enhanced by adding the polishing additives.

## Claims

1. A polishing slurry containing
(A) at least one type of raspberry-type coated particles for a polishing slurry comprising a core selected from the group consisting of metal oxides of Si, Ti, Zr, Al, Zn and mixtures thereof with a core size of from 20 to 100 nm wherein the core is coated with CeO2 particles having a particle size below 10 nm, whereby the raspberry-type coated particle is a particle comprising a core and a coating wherein the coating is deposited on the core as distinguishable dots or spheres instead of an even layer or shell, and
(B) at least one polishing additive selected from the group consisting of
(b1) compounds having at least one functional group selected from the group consisting of carboxylic acid group, carboxylate group, sulfonic acid group or sulfonategroup;
(b2) polyols having hydroxyl groups that are not dissociable in the aqueous medium; and
(b3) compounds having at least one functional group having a pKa of about 4 to about 9 and being selected from the group consisting of arylamines, aminoalcohols, aliphatic amines, heterocyclic amines, hydroxamic acids, cyclic monocarboxylic acids, unsaturated monocarboxylic acids, substituted phenols, sulfonamides, thiols, and
salts thereof;
(C) water.

2. A polishing slurry according to claim 1 wherein the core size is from 50 to 100 nm.

3. A polishing slurry according to claim 2, wherein the core size is from 50 to 80 nm.

4. A polishing slurry according to anyone of the claims 1 to 3, wherein the particles contain 50 to 97 wt.-% of the core and 3 to 50 wt.-% of CeO2 particles, based on the total weight of the raspberry-type coated particles.

5. A polishing slurry according to claim 4, wherein the particles contain 70 to 90 wt.-% of the core and 10 to 30 wt.-% of CeO2, based on the total weight of the raspberry-type coated particles.

6. A polishing slurry according to anyone of the claims 1 to 5, wherein the core is spherical.

7. A polishing slurry according to anyone of the claims 1 to 6, wherein the core is SiO2.

8. A polishing slurry according to anyone of the claims 1 to 7 which contains at least one additional component (D) such as pH adjusters, regulators or buffers, biocides, anti-foaming agents, alcohols, and surfactants.

9. A process for preparing raspberry-type coated particles according to anyone of claims 1 to 7 comprising the steps:
i) providing a mixture containing
a) core particles selected from the group consisting of metal oxides of Si, Ti, Zr, Al, Zn and mixtures thereof with a particle size of from 20 to 100 nm
b) at least one water soluble Ce-salt and
c) water,
ii) adding at least one organic or inorganic base to the mixture of step i) at temperatures of from 10 to 90 °C and
iii) aging the mixture at temperatures of from 10 to 90°C, whereby the pH-value decreases during the aging step.

10. The process according to claim 9, additionally comprising the steps of
iv) separating the particles from the mixture and
v) treating the particles at temperatures of from 150 to 400°C,

11. The process according to claim 9 or 10, wherein the water soluble Ce-salt b) is selected from the group consisting of Ce (III) nitrate, Ce (III) chloride, Ce(III) sulphate, Ammonium Ce (IV) nitrate and Ce (IV) perchlorate.

12. The process according to anyone of the claims 9 to 11, wherein the concentration of the Ce-salt b) in the mixture of step i) is from 0.5 to 6 wt.-%, based on the total weight of the mixture of step i).

13. The process according to anyone of the claims 9 to 12, wherein the concentration of the core particles a) in the mixture of step i) is from 1 to 20 wt.-%, based on the total weight of the mixture of step i).

14. The process according to anyone of the claims 9 to 13, wherein the base added in step ii) is triethylamine.

## Patentansprüche

1. Polieraufschlämmung, enthaltend
(A) mindestens eine Art von himbeerartig beschichteten Partikeln für eine Polieraufschlämmung, die einen Kern, der ausgewählt ist aus der Gruppe bestehend aus Metalloxiden aus Si, Ti, Zr, Al, Zn und Gemischen davon, mit einer Kerngröße von 20 bis 100 nm umfasst, wobei der Kern mit CeO2-Partikeln mit einer Partikelgröße von weniger als 10 nm beschichtet ist, wobei das himbeerartig beschichtete Partikel ein Partikel ist, das einen Kern und eine Beschichtung umfasst, wobei die Beschichtung auf dem Kern als unterscheidbare Punkte oder Sphären anstatt einer ebenen Schicht oder Schale aufgebracht ist, und
(B) mindestens einen Polierzusatz, ausgewählt aus der Gruppe bestehend aus
(b1) Verbindungen mit mindestens einer funktionellen Gruppe, ausgewählt aus der Gruppe bestehend aus einer Carbonsäuregruppe, Carboxylatgruppe, Sulfonsäuregruppe oder Sulfonatgruppe;
(b2) Polyolen mit Hydroxygruppen, die in dem wässrigen Medium nicht dissoziierbar sind; und
(b3) Verbindungen mit mindestens einer funktionellen Gruppe mit einem pK_{S}-Wert von etwa 4 bis etwa 9 und ausgewählt aus der Gruppe bestehend aus Arylaminen, Aminoalkoholen, aliphatischen Aminen, heterocyclischen Aminen, Hydroxamsäuren, cyclischen Monocarbonsäuren, ungesättigten Monocarbonsäuren, substituierten Phenolen, Sulfonamiden, Thiolen und Salzen davon;
(C) Wasser.

2. Polieraufschlämmung nach Anspruch 1, wobei die Kerngröße 50 bis 100 nm beträgt.

3. Polieraufschlämmung nach Anspruch 2, wobei die Kerngröße 50 bis 80 nm beträgt.

4. Polieraufschlämmung nach einem der Ansprüche 1 bis 3, wobei die Partikel, basierend auf dem Gesamtgewicht der himbeerartig beschichteten Partikel, 50 bis 97 Gew.-% von dem Kern und 3 bis 50 Gew.-% von CeO2-Partikeln enthalten.

5. Polieraufschlämmung nach Anspruch 4, wobei die Partikel, basierend auf dem Gesamtgewicht der himbeerartig beschichteten Partikel, 70 bis 90 Gew.-% von dem Kern und 10 bis 30 Gew.-% von CeO2-Partikeln enthalten.

6. Polieraufschlämmung nach einem der Ansprüche 1 bis 5, wobei der Kern sphärisch ist.

7. Polieraufschlämmung nach einem der Ansprüche 1 bis 6, wobei der Kern SiO2 ist.

8. Polieraufschlämmung nach einem der Ansprüche 1 bis 7, die mindestens eine zusätzliche Komponente (D) wie etwa pH-Einsteller, -Regler oder -Puffer, Biozide, Antischaummittel, Alkohole und Tenside enthält.

9. Verfahren zur Herstellung von himbeerartig beschichteten Partikeln nach einem der Ansprüche 1 bis 7, umfassend die Schritte:
i) Bereitstellen eines Gemischs, enthaltend
a) Kernpartikel, ausgewählt aus der Gruppe bestehend aus Metalloxiden aus Si, Ti, Zr, Al, Zn und Gemischen davon, mit einer Partikelgröße von 20 bis 100 nm,
b) mindestens ein wasserlösliches Ce-Salz und
c) Wasser,
ii) Hinzufügen mindestens einer organischen oder anorganischen Base zu dem Gemisch aus Schritt i) bei Temperaturen von 10 bis 90 °C und
iii) Altern des Gemischs bei Temperaturen von 10 bis 90 °C, wobei der pH-Wert während des Alterungsschritts abnimmt.

10. Verfahren nach Anspruch 9, zusätzlich umfassend die Schritte
iv) Trennen der Partikel von dem Gemisch und
v) Behandeln der Partikel bei Temperaturen von 150 bis 400 °C.

11. Verfahren nach Anspruch 9 oder 10, wobei das wasserlösliche Ce-Salz b) ausgewählt wird aus der Gruppe bestehend aus Ce(III)-Nitrat, Ce(III)-Chlorid, Ce(III)-Sulfat, Ammonium-Ce(IV)-Nitrat und Ce(IV)-Perchlorat.

12. Verfahren nach einem der Ansprüche 9 bis 11, wobei die Konzentration des Ce-Salzes b) in dem Gemisch aus Schritt i), basierend auf dem Gesamtgewicht des Gemischs aus Schritt i), 0,5 bis 6 Gew.-% beträgt.

13. Verfahren nach einem der Ansprüche 9 bis 12, wobei die Konzentration der Kernpartikel a) in dem Gemish aus Schritt i), basierend auf dem Gesamtgewicht des Gemischs aus Schritt i), 1 bis 20 Gew.-% beträgt.

14. Verfahren nach einem der Ansprüche 9 bis 13, wobei die in Schritt ii) hinzugefügte Base Triethylamin ist.

## Revendications

1. Suspension de polissage contenant :
(A) au moins un type de particules enrobées de type framboise pour une suspension de polissage, comprenant un noyau sélectionné dans le groupe constitué d'oxydes métalliques de Si, Ti, Zr, Al, Zn et de mélanges de ceux-ci ayant une taille de noyau de 20 à 100 nm, le noyau étant revêtu de particules de CeO₂ ayant une taille de particule inférieure à 10 nm, la particule enrobée de type framboise étant une particule comprenant un noyau et un revêtement, le revêtement étant déposé sur le noyau sous forme de points ou de sphères distincts au lieu d'une couche ou d'une coquille uniforme, et
(B) au moins un additif de polissage sélectionné dans le groupe constitué de :
(b1) composés comportant au moins un groupe fonctionnel sélectionné dans le groupe constitué d'un groupe acide carboxylique, d'un groupe carboxylate, d'un groupe acide sulfonique ou d'un groupe sulfonate ;
(b2) polyols comportant des groupes hydroxyle qui ne sont pas dissociables en milieu aqueux ; et
(b3) composés comportant au moins un groupe fonctionnel ayant une valeur pKa d'environ 4 à environ 9 et sélectionnés dans le groupe constitué d'arylamines, d'aminoalcools, d'amines aliphatiques, d'amines hétérocycliques, d'acides hydroxamiques, d'acides monocarboxyliques cycliques, d'acides monocarboxyliques insaturés, de phénols substitués, de sulfonamides, de thiols, et de sels de ceux-ci ;
(C) de l'eau.

2. Suspension de polissage selon la revendication 1, dans laquelle la taille du noyau est de 50 à 100 nm.

3. Suspension de polissage selon la revendication 2, dans laquelle la taille du noyau est de 50 à 80 nm.

4. Suspension de polissage selon l'une quelconque des revendications 1 à 3, dans laquelle les particules contiennent 50 à 97 % en poids du noyau et 3 à 50 % en poids des particules de CeO₂, relativement au poids total des particules enrobées de type framboise.

5. Suspension de polissage selon la revendication 4, dans laquelle les particules contiennent 70 à 90 % en poids du noyau et 10 à 30 % en poids de CeO₂, relativement au poids total des particules enrobées de type framboise.

6. Suspension de polissage selon l'une quelconque des revendications 1 à 5, dans laquelle le noyau est sphérique.

7. Suspension de polissage selon l'une quelconque des revendications 1 à 6, dans laquelle le noyau se compose de SiO₂.

8. Suspension de polissage selon l'une quelconque des revendications 1 à 7, laquelle contient au moins un constituant additionnel (D), tel que des agents d'ajustement ou de régulation du pH ou des tampons, des biocides, des agents antimousse, des alcools et des tensioactifs.

9. Procédé de préparation de particules enrobées de type framboise selon l'une quelconque des revendications 1 à 7, comprenant les étapes qui consistent à :
i) fournir un mélange contenant :
a) des particules de noyau sélectionnées dans le groupe constitué d'oxydes métalliques de Si, Ti, Zr, Al, Zn et de mélanges de ceux-ci ayant une taille de particule de 20 à 100 nm,
b) au moins un sel de cérium hydrosoluble, et
c) de l'eau,
ii) ajouter au moins une base organique ou inorganique au mélange de l'étape i) à des températures de 10 à 90 °C, et
iii) vieillir le mélange à des températures de 10 à 90 °C, la valeur du pH diminuant au cours de l'étape de vieillissement.

10. Procédé selon la revendication 9, comprenant en outre les étapes qui consistent à :
iv) séparer les particules du mélange, et
v) traiter les particules à des températures de 150 à 400 °C.

11. Procédé selon la revendication 9 ou 10, dans lequel le sel de cérium hydrosoluble b) est sélectionné dans le groupe constitué du nitrate de cérium (III), du chlorure de cérium (III), du sulfate de cérium (III), du nitrate d'ammonium et de cérium (IV), et du perchlorate de cérium (IV).

12. Procédé selon l'une quelconque des revendications 9 à 11, dans lequel la concentration du sel de cérium b) dans le mélange de l'étape i) est de 0,5 à 6 % en poids, relativement au poids total du mélange de l'étape i).

13. Procédé selon l'une quelconque des revendications 9 à 12, dans lequel la concentration des particules de noyau a) dans le mélange de l'étape i) est de 1 à 20 % en poids, relativement au poids total du mélange de l'étape i).

14. Procédé selon l'une quelconque des revendications 9 à 13, dans lequel la base ajoutée à l'étape ii) est la triéthylamine.
